**Europäisches Patentamt**

**European Patent Office**

**Office européen des brevets**

(19)

(11) Publication number : **0 505 051 A1**

(12) # EUROPEAN PATENT APPLICATION

(21) Application number : **92301770.1**

(22) Date of filing : **02.03.92**

(51) Int. Cl.$^5$ : **G11C 16/02**, G11C 7/00

(30) Priority : **19.03.91 US 671394**

(43) Date of publication of application :
**23.09.92 Bulletin 92/39**

(84) Designated Contracting States :
**DE FR GB IT**

(71) Applicant : **NATIONAL SEMICONDUCTOR CORPORATION**
**2900 Semiconductor Drive P.O. Box 58090**
**Santa Clara California 95051-8090 (US)**

(72) Inventor : **Intrater, Gideon**
**46 Sharet Street**
**Raimat-Gan (IL)**
Inventor : **Afek, Yachin**
**31 Geula Street**
**Kfar Saba (IL)**
Inventor : **Bernstein, Arie**
**32 Gordon Street**
**Petah-Tikva (IL)**

(74) Representative : **Bowles, Sharon Margaret et al**
**BOWLES HORTON Felden House Dower Mews High Street**
**Berkhamsted Hertfordshire HP4 2BL (GB)**

(54) **Data storage system with intrinsic burst detection.**

(57) A data storage system includes on-chip circuitry that stores the preceding reference line of data and provides fast access time to data in this line with no need for special pins to signal an "in-line" access. The system includes an array that comprises $2^K$ storage registers, each storage register storing an N-bit data element. Each register has a bit access address associated therewith. The array is responsive to K-M address bits provided at its address inputs to provide $2^M$ data elements at its data outputs. A line buffer (24) receives the $2^M$ data elements from the data output of the array. Access control (28) circuitry responds to the K-M address bits for loading the $2^M$ data elements from the data outputs of the array to the line buffer. Select circuitry (26) responds to the M address bits for transferring a single data element stored in the line buffer (24) and identified by the M address bits to the select circuit in parallel with the array access. In a preferred embodiment, the access control circuitry (28) includes means for comparing the address presented on the address inputs of the array to the address of the line stored in the line buffer (24). If the two addresses match, then the array access is aborted.

FIG. 2

## Background of the Invention:

### 1. Field of the Invention

The present invention relates to integrated circuit memory devices and, in particular, to a data storage device that includes on-chip circuitry that stores a preceding reference address, compares it to the current reference address, and initiates and "in-line" read access cycle when appropriate, thereby improving average memory access time.

### 2. Discussion of the Prior Art

An electrically programmable read-only memory (EPROM) is a non-volatile memory integrated circuit which is used to store binary information. Power can be removed from an EPROM without loss of data. That is, upon reapplying power, the originally-stored binary data is retained.

In addition to its data retention capability, an EPROM can also be reprogrammed to store a new binary bit pattern. Reprogramming is accomplished by first exposing the EPROM to an ultra-violet (UV) source in order to erase the old binary information. A UV-transparent lid on the packaged EPROM chip allows this erasure to occur. Following erasure, new binary information is written into the EPROM by deactivating the chip select line in order to switch the data outputs to inputs. The address inputs are then set to a starting value, the desired data is connected to the EPROM data inputs and the data is written into the selected data storage register of the memory array. This cycle is repeated for each EPROM storage register.

In an EPROM read operation, the storage register location selected by memory decode logic is determined by the binary value on the address inputs. The data programmed in the memory array at that location is connected to the data output buffers. If the chip select signal is activated, data is provided from the selected storage register to the data bus.

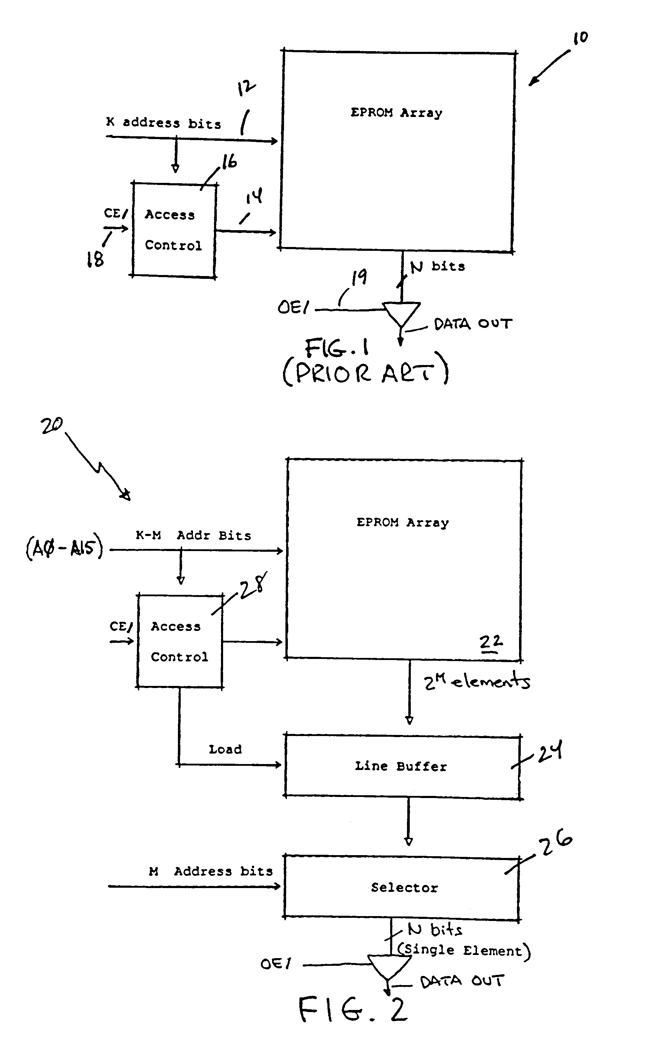

Fig. 1 shows a conventional EPROM 10 which is organized as an array of $2^K$ storage registers (N bits/register). As stated above, a K-bit address input 12 selects the storage register to be read. An array read access is initiated by either an address change (e.g. a change in any of the K address bits) or by an activation signal 14 generated by access control logic 16 in response to assertion of a chip enable control signal (CE/) 18. Data is transferred to the outputs in response to assertion of an output enable control signal (OE/) 19.

EPROM parameters are specified primarily by the EPROM's access time parameters Tacc and Tce. That is, the EPROM technical specification states that EPROM data-out signals will represent the logical value of the selected EPROM storage register at the latter of either (i) Tacc nanoseconds after an address change or (ii) Tce nanoseconds after the activation of the chip enable signal CE/ (assuming that the output enable control signal OE/ is active at least Toe nanoseconds before the latter of the above conditions).

A new class of EPROMs, burst EPROMs, provide very fast access time for "in-line" memory references. An EPROM array is typically divided into lines with four or more storage registers in each line. An access to a storage register which belongs to the same line as the preceding access is defined as an "in-line reference". System statistics show that 80-90% of memory references are "in-line". Thus, burst EPROMs dramatically decrease average memory access time.

A drawback of burst EPROM systems is that burst EPROMs require special external control signals that indicate an "in-line" sequence. This complicates the system and makes the EPROM incompatible with standard EPROMs. That is, burst EPROMs cannot use the same sockets, cannot replace standard EPROMs, cannot use the same EPROM programmers, and deviate from de facto pin out standards for conventional EPROMs.

### Summary of the Invention

The present invention provides a data storage device that includes on-chip circuitry that stores the preceding reference address, compares it to the current address and initiates an "in-line" cycle when appropriate.

In an embodiment of the invention, a burst EPROM includes an EPROM array that includes $2^K$ storage registers, each of which stores an N-bit data element. Each storage register has a bit access address associated with-it. The array is responsive to K-M address bits provided at its address inputs to provide $2^M$ data elements at its data outputs. A line buffer receives the $2^M$ data elements from the data output of the array. Access control circuitry also responds to the K-M address bits by loading the corresponding data from the data outputs of the array to the line buffer. Select circuitry responds to M address bits by transferring the single data element stored in the line buffer and identified by the M address bits to the outputs of the select circuitry.

Thus, a burst EPROM in accordance with the present invention works in parallel. When the device detects a new access, it provides the data stored in the line buffer according to the M address lines and, at the same time, starts a full access to the EPROM array. If the K-M address bits point to the same line already stored in the line buffer, then the access is "in-page" and the data is provided to the outputs with a short selector delay. If the access is not "in-page", then the full EPROM array access time is required.

In accordance with a preferred embodiment of the invention, the access control circuitry includes logic for comparing the address presented on the address inputs to the address of the line stored in the line buffer. If the two addresses match, then the array access is aborted and the referenced data element is retrieved from the line buffer. This feature reduces the power consumption of the device, since the array will be accessed only when data is required from a line which does not reside in the line buffer.

A better understanding of the features and advantages of the present invention will be obtained by reference to the following detailed description of the invention and accompanying drawings which set forth an illustrative embodiment in which the principles of the invention are utilized.

## Brief Description of the Drawings

Figure 1 is a block diagram illustrating a conventional EPROM architecture.

Figure 2 is a block diagram illustrating a burst EPROM architecture in accordance with the present invention.

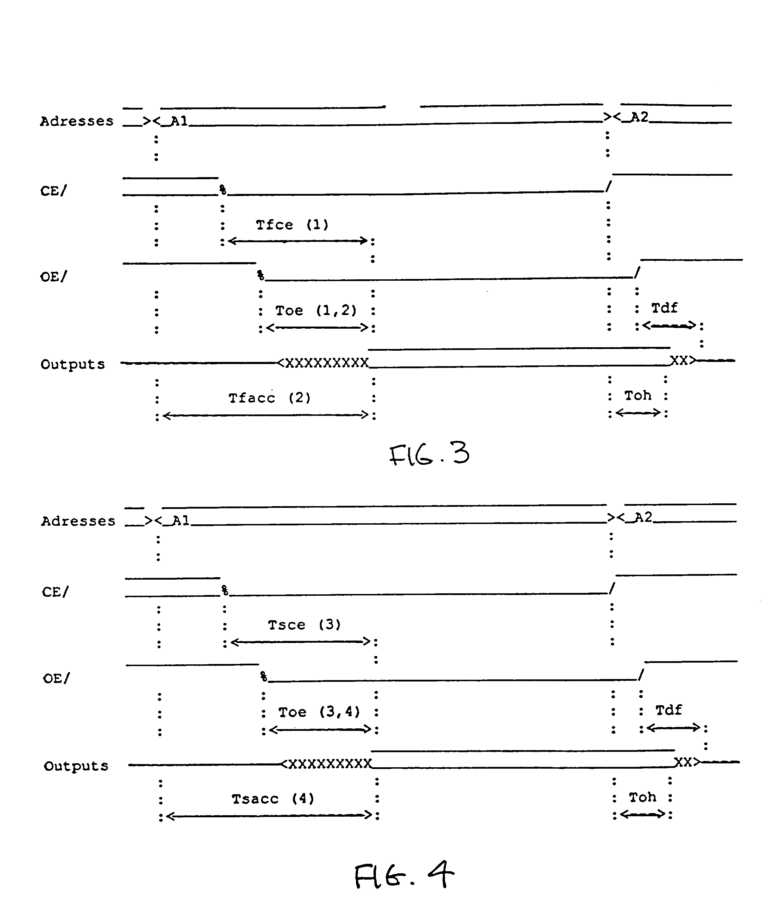

Figure 3 is a timing diagram illustrating the waveforms for an in-line read cycle performed by the Figure 2 burst EPROM.

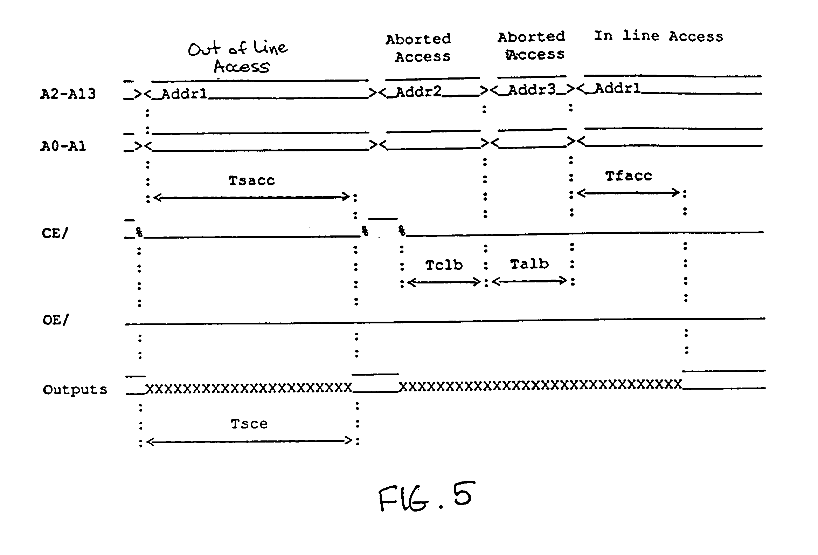

Figure 4 is a timing diagram illustrating the waveforms of an out-of-line read cycle performed by the Figure 2 burst EPROM.

Figure 5 is a timing diagram illustrating the waveforms of an out-of-line read cycle followed by two aborted accesses and an in-line read cycle performed by the Figure 2 burst EPROM.

## Detailed Description of the Invention

Fig. 2 shows a burst EPROM device 20 that includes a high speed 1024K-bit UV erasable and electrically programmable read only memory array 22.

In accordance with the present invention, the burst EPROM device 20 incorporates special circuitry to allow very fast access time to the stored data for sequential "in-line" accesses. Furthermore, the burst EPROM is 100% compatible with existing 64K X 16 EPROM devices. This compatibility allows simple integration of the burst EPROM in existing systems and the use of existing EPROM programmers to program the device.

The burst EPROM device 20 utilizes two control functions, both of which must be logically active in order to obtain data at the outputs. A chip enable control signal (CE/) is the power control and is used for device selection. An output enable signal (OE/) is the device output control and is used to gate data to the output pins when the device 20 is selected.

Data is available at the outputs at the latter of either (i) Tfacc or Tsacc nanoseconds after an address change or (ii) Tfce or Tsce nanoseconds after the activation of the chip enable signal CE/ (assuming that the output enable signal OE/ is active at least Toe nanoseconds before the latter of the above conditions).

The access time of the burst EPROM device 20 depends upon whether the access is "in-line" or "out-of-line". An access is considered "in-line" whenever bits A2-A15 of the access address (A0-A15) match bits A2-A15 of the address of the line latched in the internal line buffer 24. During "in-line" accesses, address-to-output and chip enable CE/-to-output timing are Tfacc and Tfce, respectively. During "out-of-line" accesses, address-to-output and chip enable CE/-to-output timing are Tsacc and Tsce, respectively.

The line buffer 24 is loaded with a new line whenever an access satisfies Tsacc and Tsce. The same line resides in the line buffer 24 if subsequent accesses are performed to the same line (i.e. address bits A2-A15 are the same value while chip enable CE/ is asserted (low)). The content of the line buffer 24 changes whenever a new value is presented on address inputs A2-A15 and chip enable CE/ is asserted for more than Talb or Tclb.

Thus, the burst EPROM device 20, instead of reading only one data element, reads $2^M$ storage registers from consecutive addresses into the line buffer 24. Only one of the $2^M$ registers read into the line buffer 24 is sent to the output pins of the device according to the reference address. The number of address bits that control which storage register will be sent to the output pins of the line buffer 24 is M.

The selection is done by selector logic 26. Whenever an EPROM access begins, the burst EPROM device 20 initiates a conventional array access that may require the full access-time. Concurrently, selector logic 26 uses the M least significant bits of the reference address to control which one of the data element entries of line buffer 24 will be sent to the output pins. The time required by the selector logic 26 (in-line access time) is much smaller than the full access time. Thus, whenever an access is in-line, a data element is ready much faster than if it must be retrieved from the EPROM array 22. If there are several in-line accesses, the burst EPROM device 20 will initiate several redundant array accesses which will not affect the access time, since consecutive data elements will be supplied by the selector logic 26 from the line buffer 24.

Circuitry that may be located within the access control block 28 compares the address presented on the address inputs of the EPROM array 22 to the address of the line stored on the line buffer 24. If the two addresses match, then the array access is aborted. This reduces the power consumption of the device, since the array will be accessed only when data is 1required from a line which does not reside in the line buffer.

Most modern high-end microprocessors are tuned for burst accesses. On these processors, a special pin signals the special memory system that the current access is to the same line as the last access. The system wait state generator can use this signal to provide one of two different numbers of wait states for each bus cycle, one for in-line and the other for out-of-line accesses.

The burst EPROM device 20 described above does not need these signals. It has its own unique structure that allows data to be valid at the right time for both in-line and out-of-line accesses.

It should be understood that various alternatives to the embodiments of the invention described herein may be employed in practicing the invention. For example, various-types of non-volatile memory devices (e.g., ROM, PROM, EPROM, $E^2$PROM, Flash-ROM) can utilize the same technique. With minor modifications obvious to those skilled int heart, the technique can also be utilized in random access memory devices such as SRAMs. It is intended that the following claims to find the scopes of the invention and that methods within the scope of these claims and their equivalents be covered thereby.

## Claims

1. A burst EPROM device comprising:

    (a) an EPROM array that includes $2^K$ storage registers, each storage register storing an N-bit data element, each storage register having an access address associated therewith, the array being responsive to K-M address bits provided at its address inputs to provide $2^M$ data elements at its data outputs;

    (b) a line buffer that stores the $2^M$ data elements received from the EPROM array;

    (c) access control circuitry responsive to the K-M address bits for loading the corresponding data elements from the EPROM array to the line buffer; and

    (d) select circuitry responsive to M address bits for transferring a single data element stored in the line buffer and identified by the M address bits to an EPROM device output regardless of the state of circuit elements (a), (b) and (c) above.

2. A burst EPROM system as in claim 1 wherein the access control circuitry includes:

    (a) means for comparing the address provided on the address inputs to the address of the line stored in the line buffer; and

    (b) means for aborting the EPROM array access if the comparison results in a match.

3. A method of accessing data stored in a data storage array that includes $2^K$ storage registers, each storage register having an access address associated therewith, the array being responsive to K-M address bits provided at its address inputs to provide $2^M$ data elements at its data outputs, the method comprising:

    (a) transferring the $2^M$ data elements from the data storage array to be stored in a line buffer; and

    (b) transferring one data element from the line buffer to the data storage array outputs regardless of the state of the transfer in step (a).

4. A method of accessing data stored in a data storage array that includes $2^K$ storage registers, each storage register having an access address associated therewith, the array being responsive to K-M address bits provided at its address inputs to provide $2^M$ data elements at its data outputs, the method comprising:

    (a) transferring the $2^M$ data elements from the data storage array to be stored in a line buffer;

    (b) transferring one data element from the line buffer to the data storage,array outputs regardless of the state of the transfer in step (a).

    (c) comparing the access address provided on the address inputs of the data storage array to the access address of the data elements stored in the line buffer;

    (d) if the comparison results in a match, cancelling the access to the data storage array and transferring a data element corresponding to the access address from the line buffer to the line buffer output.

FIG. 1
(PRIOR ART)

FIG. 2

FIG. 3

FIG. 4

Out of Line
Access          Aborted    Aborted    In line Access
                Access     Access

A2-A13  _><_Addr1_____><_Addr2____><_Addr3_><_Addr1_____

A0-A1   _><_____><_____><_____><_____

                Tsacc                                    Tfacc
        :<─────────────────>:                        :<──────>:

CE/     _%_____%__%_____

                                    Tclb   Talb
                                :<─────>:<─────>:

OE/     _____

Outputs __XXXXXXXXXXXXXXXXXXXXXXXX_____XXXXXXXXXXXXXXXXXXXXXXXXXXXXX_____

                Tsce
        :<─────────────────>:

FIG. 5

7

European Patent
Office

**EUROPEAN SEARCH REPORT**

Application Number

| | DOCUMENTS CONSIDERED TO BE RELEVANT | | EP 92301770.1 |
|---|---|---|---|

| Category | Citation of document with indication, where appropriate, of relevant passages | Relevant to claim | CLASSIFICATION OF THE APPLICATION (Int. Cl.5) |
|---|---|---|---|
| A | EP - A - 0 377 840 (KABUSHIKI KAISHA TOSHIBA) * Abstract; column 1, line 1 - column 5, line 22; fig. 1,3; claim 1 * | 1 | G 11 C 16/02 G 11 C 7/00 |
| A | EP - A - 0 377 839 (KABUSHIKI KAISHA TOSHIBA) * Abstract; column 1, line 1 - column 3, line 37; fig. 5; claim 1 * | 1 | |

TECHNICAL FIELDS
SEARCHED (Int. Cl.5)

G 11 C

The present search report has been drawn up for all claims

| Place of search | Date of completion of the search | Examiner |
|---|---|---|
| VIENNA | 03-07-1992 | GRÖSSING |

8